# EUROPEAN PATENT SPECIFICATION

(11) **EP 3 381 069 B1**
(45) Date of publication and mention of the grant of the patent: **30.10.2019**
(21) Application number: 16805994.7
(22) Date of filing: 22.11.2016
(51) Int. Cl.: H01L 51/00

(54) **A PROCESS OF OBTAINMENT OF AN N-TYPE OR A P-TYPE ORGANIC SEMICONDUCTOR BY UV-VIS IRRADIATION**
VERFAHREN ZUR ERHALTUNG EINES ORGANISCHEN HALBLEITERS VOM N-TYP ODER P-TYP MITTELS UV-VIS-BESTRAHLUNG
PROCÉDÉ D'OBTENTION D'UN SEMI-CONDUCTEUR ORGANIQUE DE TYPE N OU DE TYPE P PAR IRRADIATION UV-VIS

(30) Priority: 24.11.2015 ES 201531706
(43) Date of publication of application: 03.10.2018
(73) Proprietor: Consejo Superior De Investigaciones Científicas (CSIC), 28006 Madrid (ES)
(72) Inventor: CAMPOY QUILES, Mariano, 08193 Cerdanyola del Vallès (Barcelona) (ES); GOÑI TASADA, Alejandro Rodolfo, 08193 Cerdanyola del Vallès (Barcelona) (ES); DÖRLING, Bernhard, 08193 Cerdanyola del Vallès (Barcelona) (ES); MÜLLER, Christian, SE-412 96 Gothenburg (SE); RYAN, Jason, Lexington Kentucky 40511 (US)
(74) Representative: Pons
(86) International application number: PCT/EP2016/078459
(87) International publication number: WO 2017/089351

(56) References cited:
- SHIM M ET AL: "PHOTOINDUCED CONDUCTIVITY CHANGES IN CARBON NANOTUBE TRANSISTORS", APPLIED PHYSICS LETTERS, A I P PUBLISHING LLC, US, vol. 83, no. 17, 27 October 2003 (2003-10-27), pages 3564-3566, XP001192562, ISSN: 0003-6951, DOI: 10.1063/1.1622450
- CHEON TAEK HONG ET AL: "Spray-printed CNT/P3HT organic thermoelectric films and power generators", JOURNAL OF MATERIALS CHEMISTRY A: MATERIALS FOR ENERGY AND SUSTAINABILITY, vol. 3, no. 43, 5 October 2015 (2015-10-05), pages 21428-21433, XP055344634, GB ISSN: 2050-7488, DOI: 10.1039/C5TA06096F
- YEONTACK RYU ET AL: "High electrical conductivity and-type thermopower from double-/single-wall carbon nanotubes by manipulating charge interactions between nanotubes and organic/inorganic nanomaterials", CARBON, ELSEVIER, OXFORD, GB, vol. 49, no. 14, 29 June 2011 (2011-06-29) , pages 4745-4751, XP028264443, ISSN: 0008-6223, DOI: 10.1016/J.CARBON.2011.06.082 [retrieved on 2011-06-29]

## Description

The invention relates to a process of obtainment of an n-type or a p-type organic semiconductor by irradiating a p-type or an n-type organic semiconductor with UV-VIS radiation, respectively.

### STATE OF ART

A broad range of organic electronic applications rely on the availability of both p- and n-type organic semiconductors, and the possibility to deposit them as sequential layers or to form spatial patterns. Examples include transport layers in diodes (OLEDs, photovoltaics, etc), the transistor technology that underpins complementary logic and circuitry, as well as the p- and n- legs of a thermoelectric generator. Typically, a judicious selection of orthogonal solvents coupled to additive patterning techniques, such as inkjet printing, is employed to provide patterned p- and n- regions in solution-processed devices. If higher resolution is required (below ∼100 µm), multi-step lithographic methods are then compulsory.

Besides inkjet printing, organic thermoelectric generators are prepared using a variety of methods, including drop casting, spray coating or (vacuum) filtering the solution, to obtain single layers, and subsequently assembling the complete device. In all these cases, the n-type character is obtained by either molecular doping of the organic semiconductor, or by forming composites with n-type fillers, such as nitrogen doped carbon nanotubes. Shim et al "Photoinduced conductivity changes in carbon nanotube transistors" Appl. Phys. Lett. 83, 3564 (2003) describes a method for switching the conductivity type of a SNWT layer using weak UV light. It shows that low-intensity ultraviolet light significantly reduces the p-channel conductance while simultaneously increasing the n-channel conductance; these changes occur without variations in dopant concentrations.

Furthermore, organic n-type materials in particular prove difficult to handle, due to their inherent chemical instability towards oxidation in air, since their LUMO is normally located about 3 eV below the vacuum level. To circumvent this, a variety of strategies have been employed, like doping with air-stable intermediate compounds or by efforts to synthesize compounds with a precisely controlled LUMO level.

### DESCRIPTION OF THE INVENTION

It can be found in the state of the art, that fabrication processes of n- or p-type semiconducting devices usually require the deposition of both, n- and p-type materials. In the present invention only one solution of a p-type material has to be deposited and subsequently irradiated with light. Therefore, the present invention significantly simplifies the fabrication process of such kind of devices.

Because the deposition itself comprises only a single step, this automatically ensures good electrical as well as physical contact between n- and p- regions, thereby minimizing contact resistance and avoiding dewetting and delamination issues. All of this allows to reduce the minimum process complexity, by not only forgoing the deposition step for the complementary semiconductor layer, but also potentially avoiding the need for further deposition steps of metallic interconnect layers in some devices like thermoelectric generators.

When depositing complex multilayer structures from solution, a careful selection of orthogonal solvents is necessary, so as not to damage any of the exposed, underlying layers. Being able to prepare a similar structure with less deposition steps immediately relaxes requirements further, or if desired, instead allows for even more complex structures without additional cost.

The procedure also helps to obtain a higher thickness homogeneity compared to additive manufacturing.

Because the patterning is done with light, the resolution of the p- and n- regions can be increased from around 50 µm for state-of-the-art inkjet printed features, down to 1 µm for a standard photolithographic step.

Unlike prevailing n-type organic materials, which often cannot be processed or operated in atmosphere, the materials related to this invention are stable in air over weeks and months, as was demonstrated by preparing, operating and storing them in atmosphere.

A first aspect of the present invention relates to a process of obtainment of an n-type organic semiconductor or a p-type organic semiconductor according to claim 1.

In a preferred embodiment, the invention relates to a process of obtainment of an n-type organic semiconductor characterized in that the process comprises the following steps:
a) preparing a film of a p-type organic semiconductor onto a substrate;
   wherein said p-type organic semiconductor comprises
   - an n-type semiconducting nanostructure ranging a weight percent between 0.1 % and 60 %, preferably a weight percent between 20 % and 40 %; and
   - a p-type semiconducting conjugated molecule as an acceptor of electrons;
   and wherein said n-type organic semiconductor nanostructure is dispersed into the p-type semiconducting conjugated molecule; and
b) irradiating the film obtained in step (a) by UV-VIS radiation with a power between 1 mW/cm² and 100 mW/cm² and an exposure time of between 0.1 s and 600 s, preferably with a power between 40 mW/cm² and 60 mW/cm² and an exposure time between 50 s and 100 s.

The process of the invention starts with the preparation of a film of a p-type organic semiconductor which comprises
- an n-type semiconducting nanostructure ranging a weight percent between 0.1 % and 60 %; preferably a weight percent between 20 % and 40 %; and
- a p-type semiconducting conjugated molecule;
and wherein the n-type semiconducting nanostructure is dispersed into the p-type semiconducting conjugated molecule;

In semiconductors, electrical conduction is explained in terms of majority and minority carriers of electric charge. In n-type semiconductor materials, electrons are the majority carriers and holes, i.e. the vacancies left by electrons, are the minority carriers. In p-type semiconductor materials the opposite is true: the holes are the majority carriers and the electrons are the minority carriers. The carrier type can be determined experimentally using for example the Seebeck effect or the Hall effect.

In the present invention, the terms "n-type organic semiconductor and p-type organic semiconductor" are used inclusively, and refer to an n-type semiconductor and a p-type organic semiconductor, respectively, comprising at least one organic component. It is not meant to exclude further, inorganic components.

The term "n-type semiconducting nanostructure" refers herein to a material having at least one dimension below a length of 100 nm, for instance nano-scale particles, wires, rods, tubes, fibres, ribbons, sheets or platelets which exhibit n-type semiconductivity.

Preferred examples of n-type semiconducting nanostructures are N-doped carbon nanotubes, N-doped graphene sheets and graphite nanoplatelets, N-doped graphene nanoribbons, fullerenes, phosphorus doped silicon nanowires, tellurium based nanowires such as Bi₂Te₃ nanowires or PbTe nanowires), zinc oxide based nanowires, titanium oxide based nanowires, and a combination thereof.

The term "p-type semiconducting conjugated organic molecule" refers herein to conjugated polymers or conjugated small molecules i.e. organic molecules which contain extended systems of delocalized D-electrons which exhibit p-type semiconductivity. It also includes subgroups such as polyelectrolytes and donor-acceptor polymers.

Examples for p-type semiconducting conjugated organic molecules are polyalkylthiophenes, polyfluorenes, polyaniline (PANI), polyacetylene, polyphenylene vinylene (PPV), tetracyanoquinodimethane, tetrathiafulvalene, and a combination thereof. Poly(3-hexylthiophene) (P3HT), poly(3-dodecylthiophene-2,5-diyl) (P3DDT) or poly(9,9-dioctylfluorene) are preferred.

In the p-type organic semiconductor of the present invention, the n-type semiconducting nanostructure is dispersed into the p-type semiconducting conjugated molecule so that the n-type semiconducting nanostructure percolates throughout the p-type semiconducting conjugated molecule. Percolation of the n-type semiconducting nanostructure throughout the p-type semiconducting conjugated molecule starts at a weight percent (percolation concentration) of around 0.1 %; depends, for example on the length of the nanotubes and the degree of aggregation. For well dispersed and very long CNT, percolation may be obtained for really low concentrations of CNT, close to 0.1 %. In a preferred embodiment of the process of the invention, the n-type semiconducting nanostructure ranges a weight percent between 20 % and 40 %.

Step (a) of the preferred process of the invention refers to the preparation of a film of a p-type organic semiconductor onto a substrate.

Substrates could be rigid or flexible.

Substrates can be consisting of a glass, a ceramic, a metal, wood, a polymer such as a rubber, a mineral, concrete, a cellulosic material, a textile such as cotton, linen, nylon, silk, velvet and leather or biological tissues such as skin.

Preferred examples of substrates are flexible substrates selected from polyethylene terephthalate (PET), polyethylene naphthalate (PEN), polyimide, polyethylene (PE), polystyrene (PS), poly(vinyl chloride) (PVC), polytetrafluoroethylene (PTFE, Teflon), polypropylene (PP), polyuretane (PU), polyvinylidene fluoride (PVDF) and a combination thereof.

In a preferred embodiment of the process of the invention, the preparation of a film of a p-type organic semiconductor onto a substrate, this is step (a) of the process, comprises the following steps:
a1) adding a solution of a p-type semiconducting conjugated molecule comprising a p-type semiconducting conjugated molecule and a solvent to an n-type semiconducting nanostructure dispersion comprising an n-type semiconducting nanostructure and a solvent;
a2) agitating the mixture obtained in (a1) at a temperature range between -20 °C and 200 °C; preferably at a temperature range between 0 °C and 100 °C,
a3) depositing the solution obtained in step (a2) onto a substrate.

In step (a1), the p-type semiconducting conjugated molecule solution comprises a p-type semiconducting conjugated molecule as defined above, and a solvent. Examples of solvents are chlorobenzene, 1,2-dichlorobenzene, 1,4-dichlorobenzene, 1,2,4-trichlorobenzene, chloroform, toluene, o-xylene, p-xylene, water, methanol, ethanol and isopropanol.

In step (a1), the n-type semiconducting nanostructure dispersion comprises an n-type semiconducting nanostructure as described above and a solvent. Examples of solvents are chlorobenzene, 1,2-dichlorobenzene, 1,4-dichlorobenzene, 1,2,4-trichlorobenzene, chloroform, toluene, o-xylene, p-xylene, water, methanol, ethanol and isopropanol.

Step (a1) refers to the addition of a p-type semiconducting conjugated molecule solution to an n-type semiconducting nanostructure dispersion.

Step (a2) refers to the agitation of the mixture obtained in (a1) at a temperature range between -20 °C and 200°C, preferably between 0 °C and 100 °C. Agitation, such as sonication, is necessary to debundle the n-type semiconducting nanostructures.

Step (a3) relates to the deposition of the solution obtained in step (a3) onto a substrate. Possible substrates are defined above. Preferred deposition techniques are drop casting, filtering, dip coating, blade coating, slot-die coating, spray coating, bar coating, screen printing, gravure printing, flexographic printing or inkjet printing.

In a preferred embodiment, the process of the invention comprises a step (a1'), between step (a1) and step (a2), of adding a surfactant to the mixture obtained in (a1). The surfactant may help to debundle the n-type semiconducting nanostructures.

A wet film is obtained after step (a3); in this preferred embodiment of the process of the invention, step (b), i.e. the irradiation with UV-VIS radiation, is performed while the film is wet.

Preferably, the wet film obtained in step (a) has a thickness between 10 µm and 1000 µm, more preferably between 100 µm and 1000 µm.

In another preferred embodiment of the process of the invention, step (a) comprises the following steps:
steps (a1) to (a3) as described above, i.e. (a1) adding a p-type semiconducting conjugated molecule solution comprising a p-type semiconducting conjugated molecule and a solvent to an n-type semiconducting nanostructure dispersion comprising an n-type semiconducting nanostructure and a solvent; (a2) agitating the mixture obtained in (a1) at a temperature range between -20°C and 200 °C, preferably between 0 °C and 100 °C, and (a3) depositing the solution obtained in step (a2) onto a substrate;
   and
a step (a4) of drying the wet film obtained in step (a3) by evaporating the solvents.

A dried film is obtained after step (a4); this preferred embodiment of the process of the invention relates to the irradiation of the dried film with UV-VIS radiation.

In a preferred embodiment, the obtained dried film has a thickness between 10 nm and 100 µm. Preferably, the dried film obtained in step (a) has a thickness between 1 µm and 10 µm.

Another preferred embodiment of the invention relates to a process of obtainment of a p-type organic semiconductor as described above, characterized in that the process comprises the following steps:
a) preparing a film of an n-type organic semiconductor onto a substrate
   wherein said n-type organic semiconductor comprises
      - a p-type semiconducting nanostructure ranging a weight percent between 0.1 % and 80 %; and
      - an electron-rich molecule as a donor of electrons;
   and wherein said p-type semiconducting nanostructure is dispersed into the electron-rich molecule; and
b) irradiating the film obtained in step (a) by UV-VIS radiation with a power between 1 mW/cm² and 100 mW/cm² and an exposure time of between 0.1 s and 600 s.

The term "p-type semiconducting nanostructure" refers herein to a material having at least one dimension below a length of 100 nm, for instance nano-scale particles, wires, rods, tubes, fibres, ribbons, sheets or platelets which exhibit p-type semiconductivity.

Preferred examples of p-type semiconducting nanostructures are pristine single-double- and multi-walled carbon nanotubes, graphene sheets and graphite nanoplatelets, graphene nanoribbons; boron doped single- double- and multi-walled carbon nanotubes, boron doped graphene sheets and boron doped graphite nanoplatelets, boron doped graphene nanoribbons, boron doped fullerenes; boron doped silicon nanowires and a combination thereof

The term "electron-rich molecule" refers herein to n-type conjugated small molecules, n-type conjugated polymers, and other molecules that have the capacity to n-dope the p-type semiconducting nanostructure.

Preferred examples of electron-rich molecules used in the present invention are polyethylenimine (PEI), diethylenetriamine (DETA), tetramethylammonium hydroxide (TMAH), tetrakis(dimethylamino)ethylene (TDAE), 4-*H*-benzimidazol-2-yl)-*N*,*N-*dimethylbenzenamine (N-DMBI), 4-*H*-*N*,*N*-diphenylaniline (N-DPBI), triphenylphosphine (tpp), 1,3-bis(diphenylphosphino)propane (dppp).

In the n-type organic semiconductor of the present invention, the p-type semiconducting nanostructure is dispersed into the electron-rich molecule so that the p-type semiconducting nanostructure percolates throughout the electron-rich molecule. Step (a) of the preferred process of the invention refers to the preparation of a film of an n-type organic semiconductor onto a substrate. Preferably, the p-type semiconducting nanostructure of step (a) ranges a weight percent between 40 % and 80 %.

Substrates could be rigid or flexible.

Substrates can be consisting of a glass, a ceramic, a metal, wood, a polymer such as a rubber, a mineral, concrete, a cellulosic material, a textile such as cotton, linen, nylon, silk, velvet and leather or biological tissues such as skin.

Preferred examples of substrates are flexible substrates selected from polyethylene terephthalate (PET), polyethylene naphthalate (PEN), polyimide, polyethylene (PE), polystyrene (PS), poly(vinyl chloride) (PVC), polytetrafluoroethylene (PTFE, Teflon), polypropylene (PP), polyuretane (PU), polyvinylidene fluoride (PVDF) and a combination thereof.

In the present invention, the term "UV-VIS radiation" refers to a wavelength range of between 100 nm to 800 nm. UV radiation regarding a wavelength range of between 200 nm and 350 nm is preferred.

In the present invention, UV-VIS irradiation is performed in the presence of an oxygen containing atmosphere. UV light of wavelength up to ∼ 250 nm is mostly absorbed by oxygen O₂ so that ozone O₃ is produced.

The irradiation of step (b) is performed using a laser source, a diode or a lamp. Preferably, UV-VIS irradiation is performed using a lamp.

The wet or the dried film can be partially or completely exposed to UV-VIS radiation. A mask is preferably used for partially exposition of the wet or dried film to UV-VIS radiation.

UV-VIS irradiation of the films can be performed by
- rotatory movement of the UV irradiation source, i. e. including the irradiation from all angular directions; 90° irradiation (perpendicular to the film) is preferred; and
- a vertical and horizontal movement of the film

The n-type or p-type organic semiconductor obtained by the process of the invention can be used as part of an electric or electronic device.

Furthermore, the n-type or p-type organic semiconductor obtained by the process of the invention can be used as part of a thermoelectric generator.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

### BRIEF DESCRIPTION OF THE DRAWINGS

**Figure 1****.** Scanning electron micrographs of the nanostructure of four representative CNT/P3HT nanocomposites (from top left to bottom right: 30 wt% CNTs, 80 wt% CNTs, 30 wt% acid-treated CNTs, and 60s UV-treated 30 wt% CNTs). Varying amounts of CNT bundles and P3HT matrix are visible in all samples. Additionally, the 80 wt% samples contain Fe-catalyst, and in the UV-treated samples, scrap-like features are visible.
**Figure 2****.** AFM topography of the four representative CNT/P3HT nanocomposites (from top left to bottom right: 30 wt% CNTs, 80 wt% CNTs, 30 wt% acid-treated CNTs, and 60s UV-treated 30 wt% CNTs) shows that 80 wt% and UV-treated samples exhibit considerable roughness.
**Figure 3****.** Transmission X-ray micrograph measured at 399 eV, slightly above K_{α}(nitrogen). Darker areas correspond to increased absorption, due to the presence of nitrogen.
**Figure 4****.** Transmission X-ray micrograph measured at 520 eV. Darker areas correspond to increased absorption not specific to any element. They are instead indicative of increased sample thickness.
**Figure 5****.** Transmission X-ray micrograph measured at 707 eV, slightly above L_{α}(iron). Darker areas correspond to increased absorption caused by iron in the sample.
**Figure 6****.** Conductive AFM measurements of the four representative CNT/P3HT nanocomposites (from top left to bottom right: 30 wt% CNTs, 80 wt% CNTs, 30 wt% acid-treated CNTs, and 60s UV-treated 30 wt% CNTs).. The scale is proportional to the logarithm of the measured current.
**Figure 7****.** Histograms of the conductive AFM measurements of the four representative CNT/P3HT nanocomposites (from top left to bottom right: 30 wt% CNTs, 80 wt% CNTs, 30 wt% acid-treated CNTs, and 60s UV-treated 30 wt% CNTs). We relate the four main peaks to degraded P3HT (a), P3HT of increasing degree of doping (b, c), and CNTs (d).
**Figure 8****.** Dependence of thermoelectric properties on CNT concentration for as synthesized (filled circles, solid line) and acid-treated CNTs (open squares, dashed line).
**Figure 9****.** Photograph of a first proof of concept device made from five pairs of legs made from 20 wt% and 80 wt% composites on PET substrate. The device delivers a Seebeck voltage of ∼170 µV/K.
**Figure 10****.** Sample properties after UV-irradiation during deposition.
   (a) Seebeck coefficient versus UV treatment duration for samples containing 20 wt% CNTs (open triangles) and 30 wt% CNTs (filled circles). The lines serve as a guide to the eye. The error bars represent the standard deviation.
   (b) Normalized absorbance (dot-dashed lines) and PL spectra (solid lines) of 20 wt% CNT samples that have been irradiated for extraneous amounts of time.

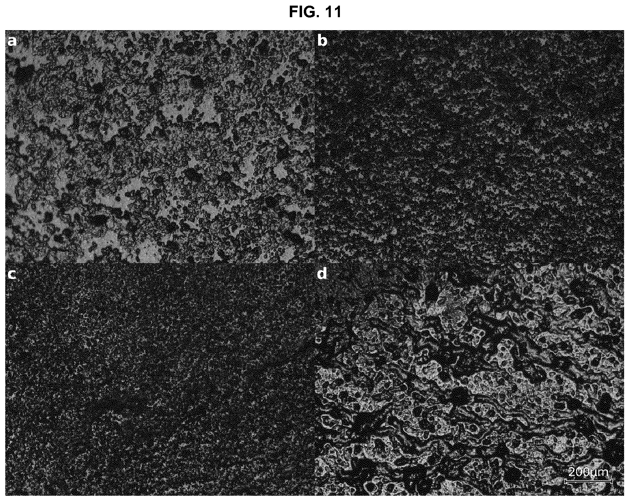

**Figure 11****.** Optical micrographs of as prepared 30 wt% CNT composite (a), and after 60s (b), 150s(c), and 240s (d) of UV irradiation. The scale bar is 200 µm.

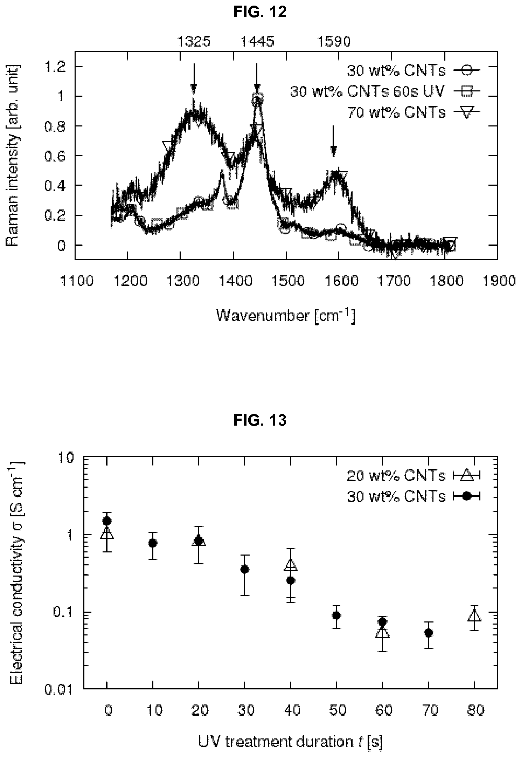

**Figure 12****.** Raman spectra of 30 wt% CNT samples before (open circles) and after 60s UV irradiation (open squares), and for a 70wt% CNT sample (open triangles). We relate the marked peaks around 1300 cm⁻¹ and 1600 cm⁻¹ to the D- and the G-band of the CNTs, and the peak at around 1450 cm⁻¹ to the symmetric C=C stretching mode of P3HT.
**Figure 13****.** Dependence of electrical conductivity on UV-treatment duration for 20 wt% (open triangles) and 30 wt% samples (filled circles). The error bars represent the standard deviation.

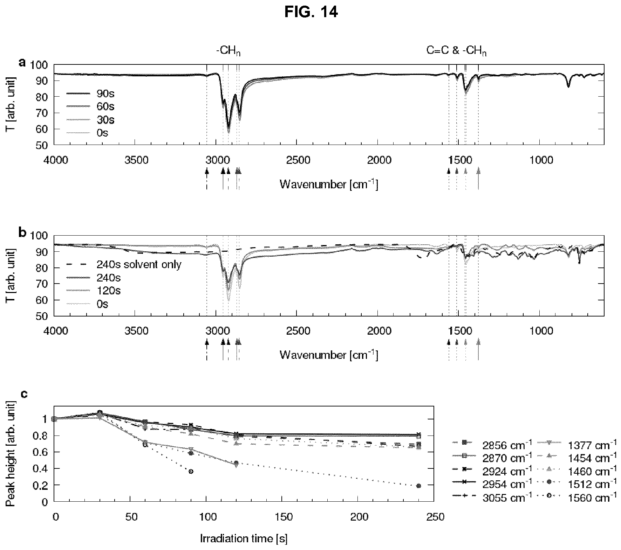

**Figure 14****.** FTIR spectra measured by attenuated total reflectance (ATR) infrared spectroscopy of P3HT solutions that have been UV-treated for different amounts of time (a, b) and a summary of relative peak heights plotted versus time (c)

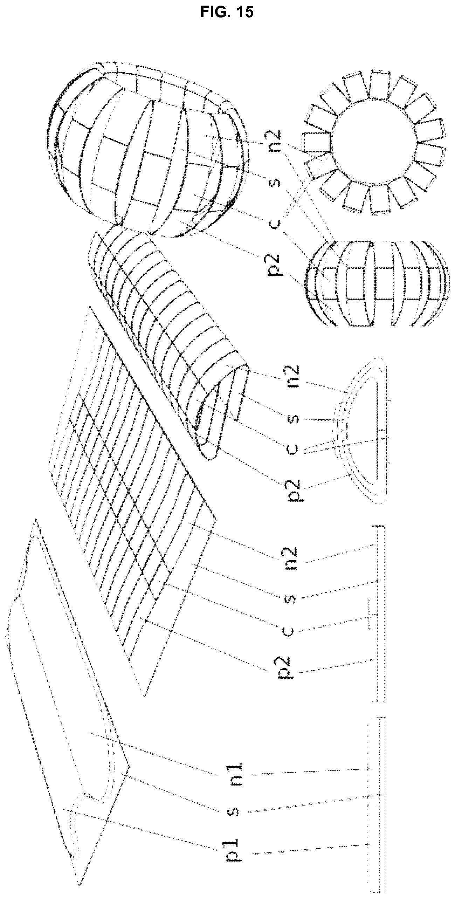

**Figure 15****.** Proposed fabrication and applications of a device geometry that plays on the advantages of the presented material. The different layers are denoted as substrate (s), electrically conducting interconnect (c), wet film of p-type solution (p1), wet film of UV-treated solution (n1), dried p-type film (p2), dried n-type film (n2).

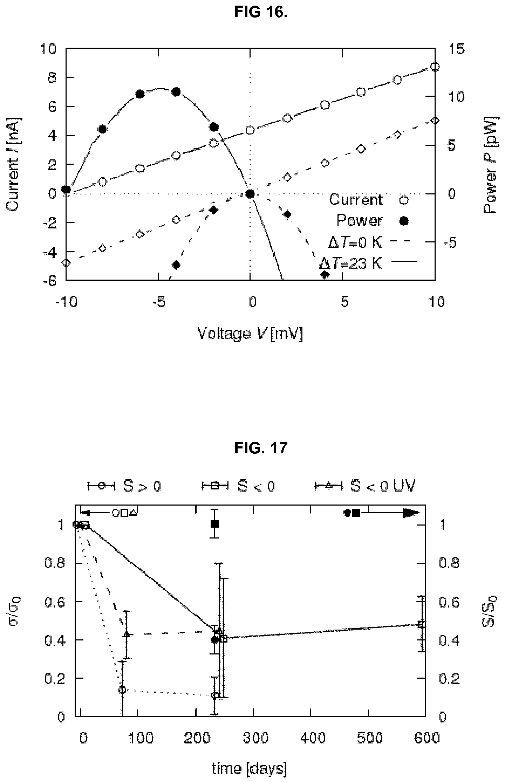

**Figure 16****.** Output current (open symbols) and output power (filled symbols) for the device with 15 pairs of legs shown in Figure 14.
**Figure 17****.** Stability of the electrical conductivity □ (open symbols) and the Seebeck coefficient S (filled symbols) over time.

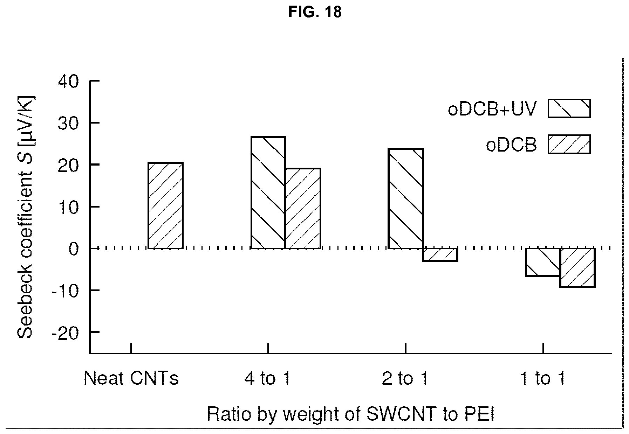

**Figure 18**. Seebeck coefficient of composites of single-walled CNTs (which are p-type due to doping with atmospheric oxygen), n-doped with electron-rich PEI.

### EXAMPLES

### Example 1: Preparation of an n-type organic semiconductor

### Preparation of CNT/P3HT composites

### Materials:

Nitrogen doped multi-walled carbon nanotubes were synthesized from a saturated solution of acetonitrile/ferrocene feedstock by chemical vapour deposition (CVD). CNTs contain approximately 7 wt% nitrogen, as determined by EELS/STEM analysis.

Poly(3-hexylthiophene-2,5-diyl) (P3HT, Mw ∼ 97 kg mol⁻¹, Mw/Mn∼2.4, regioregularity > 90%), ortho-dichlorobenzene (oDCB) (99% ReagentPlus) and chloroform (> 99.9% CHROMASOLV) were obtained from Sigma Aldrich.

### Sample preparation.

CNTs were dispersed in oDCB at a concentration of 1 gL⁻¹ and sonicated in ice water for 60 min (JP Selecta Ultrasons 50W). P3HT was dissolved in chloroform at a concentration of 20 gL⁻¹ and an appropriate amount was added in three steps to the CNT dispersion, to create a mixture with the desired CNT concentration. After each addition, the mixture was sonicated an additional 30 min in ice water. After a day, a precipitate of undissolved, residual carbon and sedimented CNTs, can be observed, the remaining solution was stable for months.

1.5 ml of solution was drop-cast onto PET substrates and left to evaporate. Some samples were irradiated with 50 mWcm⁻² of UV-light directly after solution deposition in a Jelight UVO-Cleaner 42.

### Characterization of CNT/P3HT composites

### Techniques:

*Electrical characterization.* The Seebeck coefficient was measured at 300 K and ambient atmosphere with an SB1000 instrument equipped with a K2000 temperature controller from MMR Technologies using a thermal load of about 1-2 K and a constantan wire as an internal reference. For each composition, six 5 mm by 1 mm small samples from two independently prepared films were measured; each measurement was repeated 10 times. Samples were contacted with silver paste from Agar Scientific.

The electrical conductivity measurements were performed on separate samples from the same batch. Four silver paste contacts were placed in the corners of the 1cm by 1cm samples. Conductivity was measured with an Ecopia HMS-5000 Hall measurement system, using the van der Pauw method.

*Bulk thermal conductivity*. Samples for thermal conductivity measurements were prepared by (1) solidifying material from combined 1 gL⁻¹ CNTs in ODCB and 20 gL⁻¹ P3HT in CHCl₃ solutions, (2) compacting material at ambient temperature and a pressure of 18.5 kNcm⁻² to form two identical round pellets with a diameter of 13 mm, and (3) hot-pressing pellets at 150 °C at a pressure of less than 7.4 kNcm⁻². The density was estimated by measuring the volume and weight of the pellets. The heat capacity and thermal diffusivity were measured at ambient temperature with a TPS 2500 S piece of equipment from Hotdisk AB using an isotropic model.

*Physical characterization*. Sample thickness was measured using a KLA Tencor MicroXAM-100 optical surface profilometer for samples with 50 wt% CNTs and below. Samples with higher CNT concentration were measured using a KLA Tencor P16+ profilometer. Sample thickness ranged between 15 µm and 0.8 µm, depending on the total solution concentration. For high CNT wt% composites, the samples contain a significant amount of voids, and consequently the total amount of material is overestimated.

*Optical characterization*. Transmission spectra of samples were measured using a GES-5E ellipsometer from Sopralab. Raman and photoluminescence spectra were measured in backscattering configuration with a LabRam HR800 spectrometer (Horiba JobinYvon) coupled to a confocal Olympus microscope, using 514 nm and 633 nm excitation wavelengths. Optical micrographs were taken using an Olympus BX51 optical microscope and a DP20 microscope digital camera.

*Structural characterization*. Scanning electron microscopy was conducted using a FEI Quanta 200 FEG. Atomic Force Microscopy (AFM) and Current sensing AFM were measured using an Agilent 5500LS instrument with a Rocky Mountain Nanotechnology solid platinum tip. TXM was conducted at the MISTRAL beamline at the ALBA synchrotron. For this, samples were drop-cast onto copper grids.

### Results

Composites with different stoichiometries, and post-treatments were prepared. Table 1 shows the compositions and treatments applied to each composite.

**Table 1:**

| **Composites** |
|---|
| 2.5; 5; 10; 20; 30; 40; 50; 60; 70; 80 wt% CNTs |
| 5; 30; 50; 70 wt% acid-treated CNTs |
| 20 wt% composites UV irradiated for 20, 40, 60, 80 seconds |
| 30 wt% composites UV irradiated for 10, 20, 30, 40, 50 60, 70, 80, 90, 120, 150, and 240 seconds |

Four representative CNT/P3HT composites were selected and are summarized in Table 2.

**Table 2: Representative CNT/P3HT composites:**

| | |
|---|---|
| (a) 30 wt% CNTs | (b) 80 wt% CNTs |
| (c) 30 wt % acid treated CNTs | (d) 30 wt% CNTs 60s UV-treated |

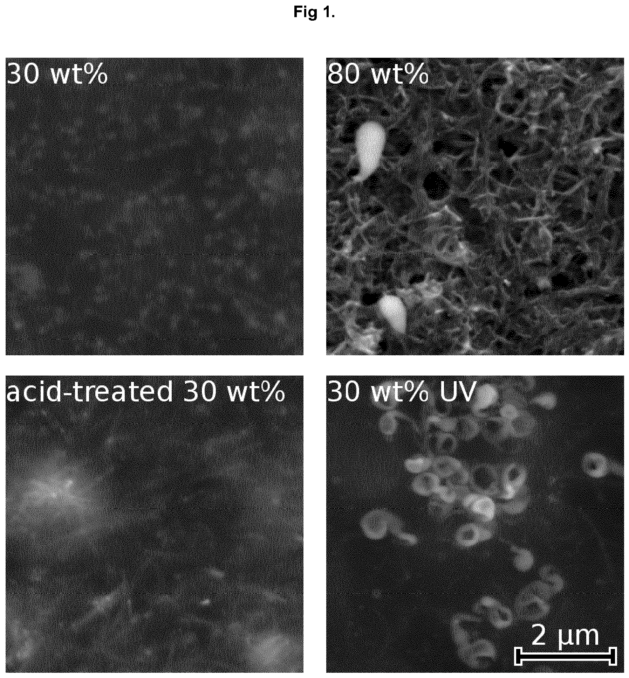

Figure 1 shows the Scanning electron micrographs of the nanostructure of four representative CNT/P3HT nanocomposites given in Table2 (from top left to bottom right: (a) 30 wt% CNTs, (b) 80 wt% CNTs, (c) 30 wt% acid-treated CNTs, and (d) 60s UV-treated 30 wt% CNTs). Varying amounts of CNT bundles and P3HT matrix are visible in all samples. Additionally, the 80 wt% samples contain Fe-catalyst, and in the UV-treated samples, scrap-like features are visible.

Scanning electron microscopy (SEM) images of composites of P3HT and nitrogen doped multi-walled CNTs with low CNT content (c ∼ 30 wt%) appear well dispersed, while high CNT content samples (c ∼ 80 wt% CNTs) exhibit agglomeration (Figure 1a). In all cases, we observe thick fibrillar structures with a diameter of 90 ± 30 nm, which are likely CNT bundles wrapped with polymer.

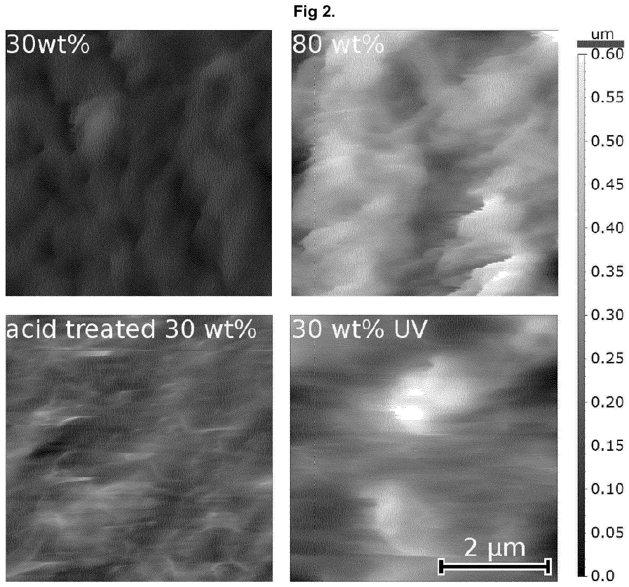

Figure 2 shows AFM topography of the four representative CNT/P3HT nanocomposites (from top left to bottom right: 30 wt% CNTs, 80 wt% CNTs, 30 wt% acid-treated CNTs, and 60s UV-treated 30 wt% CNTs) shows that 80 wt% and UV-treated samples exhibit considerable roughness.

Moreover, Atomic force microscopy (AFM) images reveal an increase in surface roughness with increasing CNT content (Figure 2). The resulting films clearly show a fine fibrillar structure with an average bundle diameter of 55 ± 15 nm, which is significantly smaller than for the high CNT content samples (Figure 1 and 2).

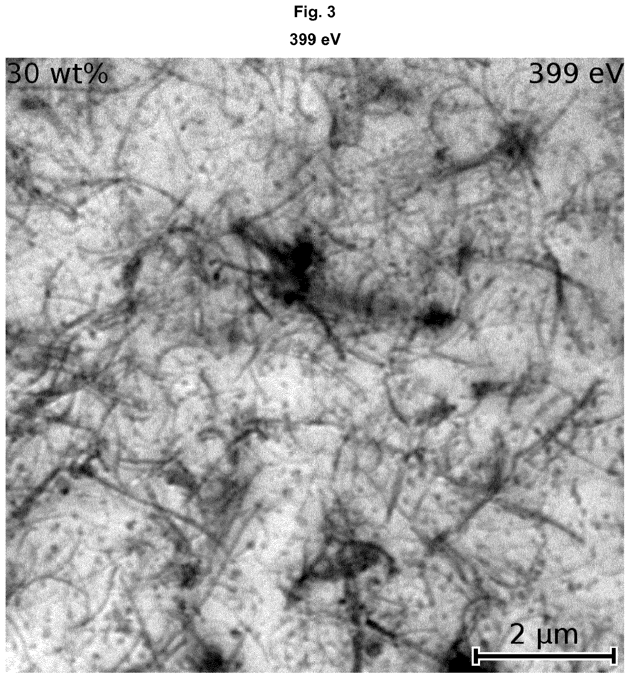

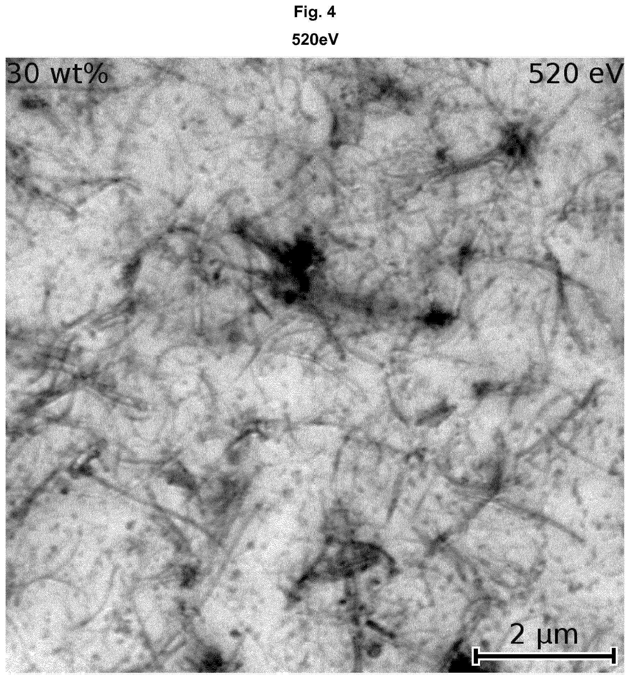

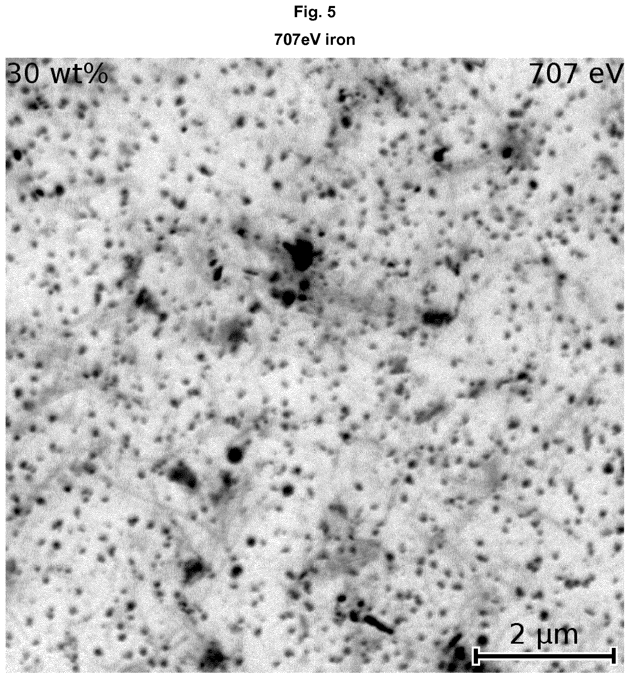

Figure 3, 4 and 5 shows Transmission X-ray micrographs measured at 399 eV, 520 eV and 707 eV, respectively. The measurements depicted in Figure 3 are slightly above K_{α}(nitrogen). Darker areas correspond to increased absorption, due to the presence of nitrogen. Darker areas shown in Figure 4 correspond to increased absorption not specific to any element. They are instead indicative of increased sample thickness. The measurements depicted in Figure 5 are slightly above L_{α}(iron). Darker areas correspond to increased absorption caused by iron in the sample.

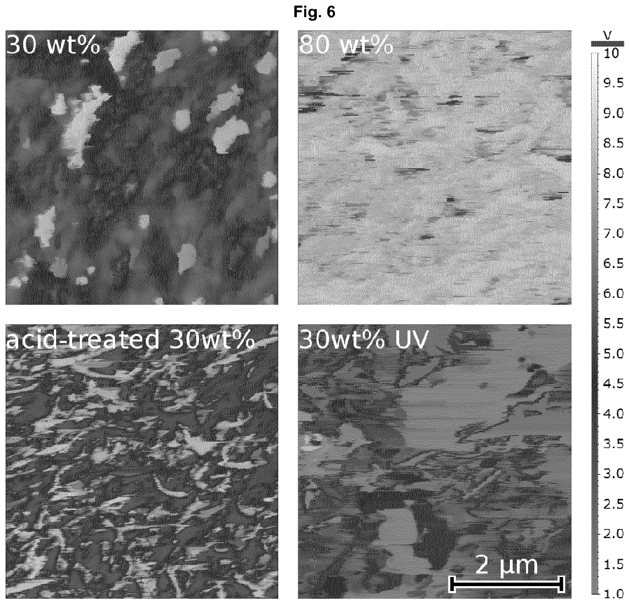

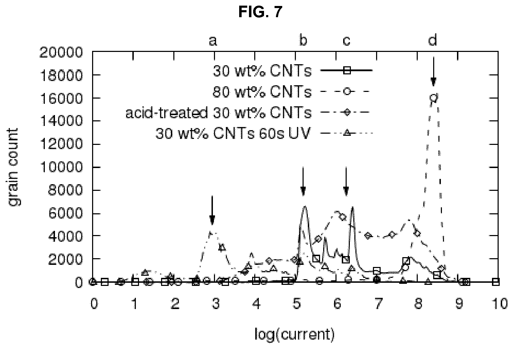

We employed transmission X-ray microscopy (TXM) to confirm that the CNTs are distributed homogeneously all throughout the thickness of the film, as well as on the surface (Figure 3, 4 and 5). TXM also reveals the presence of iron-rich clusters in the sample, that is, residuals from the CNT synthesis
Figure 6 shows the Conductive AFM measurements of the four representative CNT/P3HT nanocomposites (from top left to bottom right: 30 wt% CNTs, 80 wt% CNTs, 30 wt% acid-treated CNTs, and 60s UV-treated 30 wt% CNTs) and Figure 7 the histograms of said conductive AFM measurements. The four main peaks are related to degraded P3HT (a), P3HT of increasing degree of doping (b, c), and CNTs (d). Electrically, the composites consist of highly conductive, CNT-rich regions surrounded by polymer-rich regions that exhibit *circa* four orders of magnitude lower electrical conductivity (Figure 6 and 7).

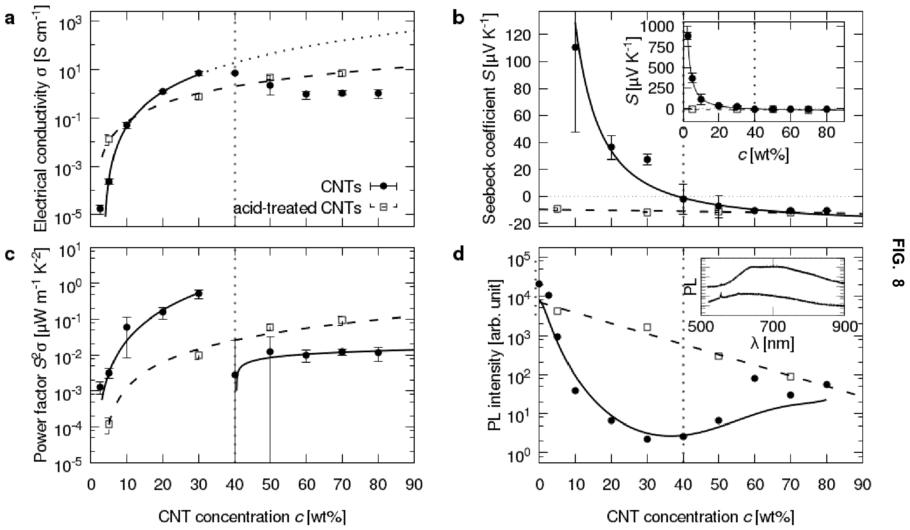

Figure 8 shows the dependence of thermoelectric properties on CNT concentration for as synthesized (filled circles, solid line) and acid-treated CNTs (open squares, dashed line).
   (a) The electrical conductivity σ shows percolative behavior, increasing by several orders of magnitude upon addition of a few wt% of CNTs. At high CNT content, a dip in σ is observed for as synthesized CNTs. The dotted line sketches the expected behavior for similar composites prepared from regular, undoped CNTs.
   (b) Correspondingly, S steadily decreases with increasing CNT concentration, and crosses over to negative values at cₛ = 40 wt% CNTs. For higher CNT concentrations, S saturates at about -10 µVK⁻¹. For the acid-treated CNTs, S is independent of the CNT concentration in the investigated range. The inset shows the complete measured composition range.
   (c) Resulting power factor S²σ. For as synthesized CNTs, two regions are apparent, one below cₛ, where the composite has p-type properties, and another above cₛ, where the material is n-type.
   (d) Averaged PL intensity between 675 nm and 725 nm, for samples excited at 514 nm. The inset shows two representative spectra with c = 0 wt% and c = 80 wt%.Error bars indicate the standard deviation across 2 batches of 6 samples each.

Macroscopically, drop cast films on PET substrates present an electrically percolating behavior as a function of CNT content, with a percolation threshold around cₚ ∼ 3.5 wt% (Figure 8a).This threshold points to relatively well dispersed carbon nanotubes, in agreement with the SEM, AFM, and TXM data shown in Figure 1.

To benchmark thermoelectric materials, the dimensionless figure of merit *ZT* = *S*²σ*T*/κ is typically used, where S is the Seebeck coefficient (S > 0 for p-type and < 0 for n-type semiconductors), σ the electrical conductivity, κ the thermal conductivity, and *T* the average absolute temperature.

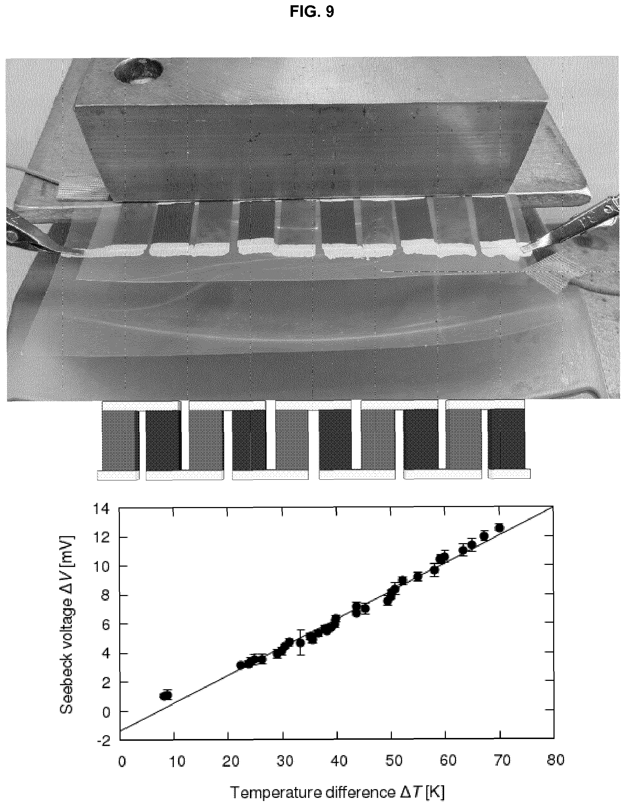

The macroscopic σ also increases sharply, in this case by five orders of magnitude, when comparing the neat polymer and composites with weight fractions above percolation. Interestingly, the Seebeck coefficient varies from that of the neat polymer (∼1000 µVK⁻¹) to that of the CNTs (∼ -10 µVK⁻¹) and correlates well with the percolation threshold observed for σ (Figure 8b). Strikingly, at around cₛ ∼ 40 wt% CNT content, the Seebeck coefficient changes sign. The corresponding power factor has two regimes, accordingly, separated by a zero value. Simple modules can be fabricated using these composites, with *p*- legs with c=20 wt%, and *n*- legs with c = 80 wt%. One example consisting of five pairs of such legs is shown in Figure 9 and delivers a thermovoltage of 170 µVK⁻¹ which is close to the sum of Seebeck coefficients of the constituting legs.

Since cₚ<<cₛ, the majority carriers for c∼25 wt% of CNTs are holes, or, in other words, holes are being transported through the CNTs, which is the electrically more conductive part of the composite. P3HT is effectively doping the CNTs. This is supported by photoluminescence (PL) quenching experiments (Figure 8d), which indicate that there is a strong photoinduced charge transfer between P3HT and CNTs. The observed phenomenology can be well explained in terms of a simple band model, which assumes that the semiconducting CNTs are being co-doped by substitutionally incorporated nitrogen atoms, and P3HT adsorbed on the surface. The Fermi level and the majority charge carrier are then determined by the specific amount of dopants. Furthermore, these composites exhibit thermochromism in solution when heated. Upon increasing the temperature, the composite solution turns from a characteristic dark purple, indicative of π-stacked/crystalline P3HT, to the bright orange coloration associated with well dissolved (amorphous/isolated) P3HT. Unfortunately, this change is not preserved through the transition to the dried film, as no changes of the thermoelectric properties are observed. Conversely, a reference P3HT solution does not show any changes during preparation and subsequent heating.

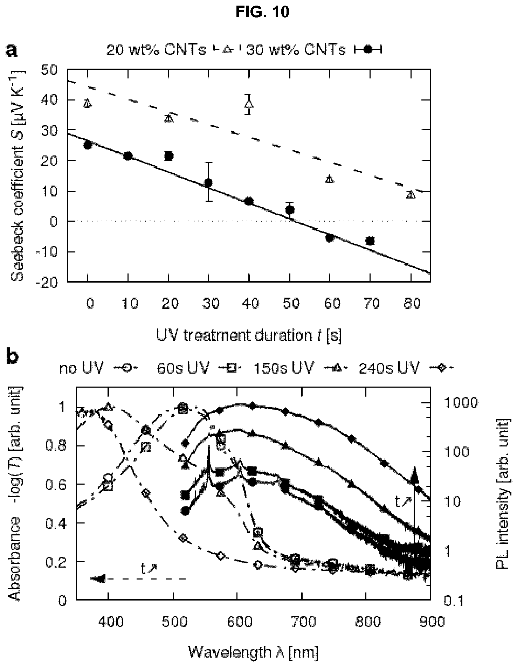

For samples that were UV-irradiated while drying using a low pressure mercury vapor lamp, the Seebeck coefficient continuously decreases as a function of irradiation time for the investigated samples, which contain 20 wt% and 30 wt% CNTs (Figure 10a). For the 30 wt% samples, S becomes negative after 60s of UV-irradiation.

In order to understand the impact of UV-irradiation on the thermoelectric properties, we next investigate its effect on the structural and optical properties of the composites.

Optical microscopy indicates that long exposure times (≥ 120 s) yield visibly degraded samples (Figure 11).

AFM also suggests an increase in surface roughness (Figure 2), while SEM evidences the appearance of small curled scraps (Figure 1), that are electrically insulating (Figure 6 and 7), which we ascribe to degraded polymer.

Raman scattering suggests that UV-light has no negative effect on the CNTs (as measured by the ratio of the D and G bands, Figure 12). Overall, long exposure times clearly degrade the samples and as a result, the macroscopic electric conductivity also slightly decreases (Figure 13).

Figure 10b shows the normalized absorption and PL intensities of four samples irradiated for 0 s, 60 s, 150 s and 240 s. The aforementioned degradation is here seen as an absorption blue-shift, which probably occurs due to a reduction in conjugation length of the polymer. The PL quenching that we discussed before is, upon UV irradiation, much less pronounced, demonstrating a lower degree of charge transfer between degraded polymer chains and CNTs, with the concomitant smaller degree of p-doping of the CNTs.

Figure 10b also shows that there are two clear regimes: for low exposure times (<60 s), there is little degradation of the polymer (no photobleaching, no absorption blue shift, high degree of PL quenching) but a strong change in the electronic properties, as observed by the change in Seebeck sign. Instead, long exposure times (>120 s) result in complete degradation of the polymer with strong negative effects on the electronic properties too. The Fourier transform infrared (FTIR) spectra shown in Figure 14 back up this observation, and provide evidence that the UV treatment attacks both the carbon double bonds of the thiophene ring, as well as the alkyl side chains, influencing the doping not only by reducing conjugation, but also by impairing the CNT-P3HT interaction.

The characteristic peaks of P3HT are related with excitations of the =C-H groups (3055 cm⁻¹), C-H₂ (2924 cm⁻¹, 2856 cm⁻¹, 1454 cm⁻¹), C-H₃ (2954 cm⁻¹, 2870 cm⁻¹, 1377 cm⁻¹) and the C=C thiophene bonds (1560 cm⁻¹, 1512 cm⁻¹, 1460 cm⁻¹). A slight decrease of absorption of these modes is observed with increasing UV treatment time (a, c). This decrease is more pronounced for longer treatment durations (b, c), However an additional effect due to the solvent is then observed.

A thermoelectric module fabricated from a single solution with p- and (UV-irradiated) n-legs was realized. Figure 15 illustrates a proof of concept thermoelectric module and some envisaged applications that are implemented through a toroidal geometry of the module.

The fabrication is detailed in Figure 15. First a uniform wet layer of the composite is deposited on a substrate (s), and part of it is UV-irradiated during drying, resulting in a wet film without treatment (p1) and a wet film that did receive UV treatment (n1). Secondly, the individual legs (p2, n2) of the dried film are patterned by appropriate cutting. We connected p- and n-type legs with an electrical conductor (c) in order to strengthen the bridge region. Then, the device is folded into a spiral, and adjacent couples are connected electrically in series by depositing contacts (c). Lastly, the ends of this spiral are joined to form a torus. Possible applications for this geometry are in the form of a single torus, an extended spiral, and a wristband.

When one side of this module comprising 15 double legs is attached to a glass filled with ice water, leaving the other side at room temperature, it generates a voltage of 5 mV which corresponds to 217.4 µVK⁻¹ or 14.5 µV K⁻¹ per couple. A plot of the output current and power versus voltage is given in Figure 16. The module supplies ~2 nA at 5 mV Seebeck voltage. An alternative geometry may allow connecting a larger number of legs to harvest, for instance, waste heat from a pipe. For this, the spiral itself can be wound into yet another spiral.

Importantly, we have measured the bulk thermal conductivity of selected bulk samples and verify that k only slightly increases from 0.29 Wm⁻¹K⁻¹ for neat P3HT to 0.55 Wm^{- 1}K⁻¹ for a c = 80 wt% composite.(see Table 3). The non-optimized ZT values are then, around 10⁻³ and 10⁻⁵ for the p-type and *n*-type composite respectively.

All samples were prepared, measured and stored in atmosphere. Figure 17 shows the results of repeated electrical measurements carried out over a period of up to 600 days. For n-type composites, the conductivity stabilized at 41 % of the initial value, with both high CNT content and UV treated samples following a similar trend. The negative Seebeck coefficient of these samples was stable for every single measured n-type sample, with no significant changes observed after 240 days. In the same amount of time, the Seebeck coefficient of p-type samples diminished to 40 % of the initial value and the electrical conductivity to 11 % of of the initial value.

**Table 3. Measured properties used to determine the thermal conductivity κ of bulk P3HT-CNT samples with 13 mm diameter.**

| | Density ρ [g cm⁻³] | Specific heat Cₚ [J kg⁻¹ K⁻¹] | Thermal diffusivity α [mm² s⁻¹] | Thermal conductivity κ [Wm⁻¹K⁻¹] |
|---|---|---|---|---|
| pure P3HT | 1.05 ± 0.01 | 1496.79 ± 14.77 | 0.18 ± 0.00 | 0.29 ± 0.01 |
| 30 wt% CNTs | 1.17 ± 0.01 | 1193.52 ± 2.08 | 0.35 ± 0.01 | 0.49 ± 0.02 |
| 30 wt% acid-treated CNTs | 1.13 ± 0.01 | 1233.62 ± 3.78 | 0.29 ± 0.00 | 0.40 ± 0.03 |
| 80 wt% CNTs | 1.21 ± 0.01 | 947.72 ± 1.90 | 0.48 ± 0.01 | 0.55 ± 0.04 |

### Example 2: Preparation of a p-type organic semiconductor

SG65i CoMoCAT SWCNTs (SouthWest NanoTechnologies) containing ≈ 40 % (6,5) tubes which are p-type due to doping by atmospheric oxygen, and branched polyethylenimine (PEI, Mw ≈ 800 g mol⁻¹, Mw/Mn ≈ 1.33), an electron-rich polymer, were bought from SigmaAldrich.

CNTs were dispersed in oDCB at a concentration of 0.5 g L⁻¹ and sonicated in ice water for 60 min.

PEI was added in three steps, followed each time by 30 min sonication.

The prepared solution was drop-cast onto PET substrates and left to evaporate.

Samples were irradiated for 60 s with 50 mW cm⁻² of UV-light directly after deposition in a Jelight UVO-Cleaner 42.

Fig. 18 shows the measured Seebeck coefficient for samples of different composition, with and without UV-treatment. Concretely, Fig. 18 shows the Seebeck coefficient of composites of single-walled CNTs (which are p-type due to doping with atmospheric oxygen), n-doped with electron-rich PEI.

Increasing the concentration of PEI in the composites in all cases reduces the Seebeck coefficient.

n-type samples are obtained for a concentration of PEI greater than 33 wt%.

The UV-treatment has the opposite effect, increasing the Seebeck coefficient of all studied samples.

If choosing a suitable composition, it is thus possible to obtain a p-type material by UV-treating an n-type material.

In this particular example, this was observed for a composite containing 66 wt% SWCNTs and 33 wt% PEI.

## Claims

1. A process of obtainment of an n-type organic semiconductor from a p-type semiconductor or a p-type organic semiconductor from an n-type organic semiconductor comprising the following steps:
a) preparing a film of a p-type organic semiconductor or a n-type organic semiconductor onto a substrate respectively,
wherein the organic semiconductor comprises a semiconducting nanostructure and an acceptor or donor of electrons respectively; and
b) irradiating the film obtained in step (a) by UV-VIS radiation with a power between 1 mW/cm² and 100 mW/cm² **characterized in that** the exposure time is between 0.1 s and 600 s and the process is performed in the presence of an oxygen containing atmosphere.

2. A process of obtainment of an n-type organic semiconductor from a p-type semiconductor according to claim 1, **characterized in that** the process comprises the following steps:
a) preparing a film of a p-type organic semiconductor onto a flexible substrate, said flexible substrate selected from polyethylene terephthalate, polyethylene naphthalate, polyimide, polyethylene, polystyrene, poly(vinyl chloride), polytetrafluoroethylene, polypropylene, polyurethane, polyvinylidene fluoride and a combination thereof.
wherein said p-type organic semiconductor comprises
• an n-type semiconducting nanostructure ranging a weight percent between 0.1 % and 60 %; said n-type semiconducting nanostructure selected from the list consisting of N-doped carbon nanotubes, N-doped graphene sheets and graphite nanoplatelets, N-doped graphene nanoribbons, fullerenes, phosphorus doped silicon nanowires, tellurium nanowires such as Bi₂Te₃ nanowires or PbTe nanowires, zinc oxide based nanowires, titanium oxide based nanowires and a combination thereof, and
• a p-type semiconducting conjugated molecule said p-type semiconducting conjugated organic molecule selected from polyalkylthiophenes, polyfluorenes, polyaniline, polyacetylene, polyphenylene vinylene, tetracyanoquinodimethane, tetrathiafulvalene and a combination thereof.;
and wherein said n-type semiconducting nanostructure is dispersed into the p-type semiconducting conjugated molecule; and
b) irradiating the film obtained in step (a) by UV-VIS radiation with a power between 1 mW/cm² and 100 mW/cm² and an exposure time of between 0.1 s and 600 s, and in the presence of an oxygen containing atmosphere.

3. The process according to claim 2, wherein the p-type semiconducting conjugated organic molecule of step (a) is poly(3-hexylthiophene), poly(3-dodecylthiophene-2,5-diyl) or poly(9,9-dioctylfluorene).

4. The process according to any of claims 2 or 3, wherein the n-type semiconducting nanostructure of step (a) ranges a weight percent between 20 % and 40 %.

5. The process according to any of claims 2 to 4, wherein step a) comprises the following steps:
a1) adding a p-type semiconducting conjugated molecule solution comprising a p-type semiconducting conjugated molecule and a solvent to an n-type semiconducting nanostructure dispersion comprising an n-type semiconducting nanostructure and a solvent;
a2) agitating the mixture obtained in (a1) at a temperature range between -20 °C and 200 °C; and
a3) depositing the solution obtained in step (a2) onto a substrate.

6. The process according to claim 5, wherein step (a2) is performed at a temperature range between 0 °C and 100 °C.

7. The process according to any of claims 5 or 6, **characterized in that** comprises a step (a1'), between step (a1) and step (a2), of adding a surfactant to the mixture obtained in (a1).

8. The process according to any of claims 5 to 6, wherein the wet film obtained in step (a3) has a thickness between 10 µm and 1000 µm,

9. The process according to claim 8, wherein the wet film obtained in step (a3) has a thickness between 100 µm and 1000 µm.

10. The process according to any of claims 1 to 9, wherein step a) comprises the following steps:
steps (a1) to (a3) according to any of claims 7 or 8; and
a step (a4) of drying the wet film obtained in step (a3) by evaporating the solvents, wherein the dried film obtained in step (a4) has a thickness between 10 nm and 100 µm.

11. The process according to claim 10, wherein the dried film obtained in step (a4) has a thickness between 1 µm and 10 µm.

12. The process of obtainment of a p-type organic semiconductor from an n-type organic semiconductor according to claim 1, **characterized in that** the process comprises the following steps:
a) preparing a film of a n-type organic semiconductor onto a flexible substrate and selected from polyethylene terephthalate, polyethylene naphthalate, polyimide, polyethylene, polystyrene, poly(vinyl chloride), polytetrafluoroethylene, polypropylene, polyurethane, polyvinylidene fluoride and a combination thereof,
wherein said n-type organic semiconductor comprises
• a p-type semiconducting nanostructure ranging a weight percent between 0.1 % and 80 %; selected from pristine single-double- and multi-walled carbon nanotubes, graphene sheets and graphite nanoplatelets, graphene nanoribbons; boron doped single- double- and multi-walled carbon nanotubes, boron doped graphene sheets and boron doped graphite nanoplatelets, boron doped graphene nanoribbons, boron doped fullerenes and a combination thereof; and
• an electron-rich molecule selected from polyethylenimine (PEI), diethylenetriamine (DETA), tetramethylammonium hydroxide (TMAH), tetrakis(dimethylamino)ethylene (TDAE), 4-H-benzimidazol-2-yl)-N,N-dimethylbenzenamine (N-DMBI), 4-H-N,N-diphenylaniline (N-DPBI), triphenylphosphine (tpp), 1,3-bis(diphenylphosphino)propane (dppp);
and wherein said p-type semiconducting nanostructure is dispersed into the electron-rich molecule; and
b) irradiating the film obtained in step (a) by UV-VIS radiation with a power between 1 mW/cm² and 100 mW/cm² and an exposure time of between 0.1 s and 600 s, and in the presence of an oxygen containing atmosphere.

13. The process according to claim 12, wherein the p-type semiconducting nanostructure of step (a) ranges a weight percent between 40 % and 80 %.

14. The process according to any of claims 1 to 13, wherein step (b) is performed by UV-VIS radiation with a power between 40 mW/cm² and 60 mW/cm² and an exposure time of between 50 s and 100 s.

15. The process according to any of claims 1 to 14, wherein step (b) is performed using a laser source, a diode or a lamp.

## Patentansprüche

1. Verfahren zur Erhaltung eines organischen Halbleiters vom n-Typ aus einem Halbleiter vom p-Typ oder eines organischen Halbleiters vom p-Typ aus einem organischen Halbleiter vom n-Typ, umfassend die folgenden Schritte:
a) Herstellen eines Films eines organischen Halbleiters vom p-Typ oder eines organischen Halbleiters vom n-Typ auf einem jeweiligen Substrat, wobei der organische Halbleiter eine halbleitende Nanostruktur und einen Akzeptor bzw. Donor von Elektronen umfasst; und
b) Bestrahlen des in Schritt (a) erhaltenen Films mit UV-VIS-Strahlung mit einer Leistung zwischen 1 mW/cm² und 100 mW/cm², **dadurch gekennzeichnet, dass** die Belichtungszeit zwischen 0,1 s und 600 s liegt und das Verfahren in Gegenwart einer sauerstoffhaltigen Atmosphäre durchgeführt wird.

2. Verfahren zur Erhaltung eines organischen Halbleiters vom n-Typ aus einem Halbleiter vom p-Typ nach Anspruch 1, **dadurch gekennzeichnet, dass** das Verfahren die folgenden Schritte umfasst:
a) Herstellen eines Films eines organischen Halbleiters vom p-Typ auf einem flexiblen Substrat, wobei das flexible Substrat ausgewählt ist aus Polyethylenterephthalat, Polyethylennaphthalat, Polyimid, Polyethylen, Polystyrol, Poly(vinylchlorid), Polytetrafluorethylen, Polypropylen, Polyurethan, Polyvinylidenfluorid und einer Kombination davon,
wobei der organische Halbleiter vom p-Typ umfasst
• eine halbleitende Nanostruktur vom n-Typ mit einem Gewichtsprozentbereich zwischen 0,1% und 60%; wobei die halbleitende Nanostruktur vom n-Typ ausgewählt ist aus der Liste, bestehend aus N-dotierten Kohlenstoffnanoröhren, N-dotierten Graphenfolien und Graphitnanoplättchen, N-dotierten Graphennanobändern, Fullerenen, phosphordotierten Siliziumnanodrähten, Tellurnanodrähten wie Bi₂Te₃-Nanodrähten oder PbTe-Nanodrähten, Nanodrähten auf Zinkoxidbasis, Nanodrähten auf Titanoxidbasis und einer Kombination davon, und
• ein halbleitendes konjugiertes Molekül vom p-Typ, wobei das halbleitende konjugierte organische Molekül vom p-Typ ausgewählt ist aus Polyalkylthiophenen, Polyfluorenen, Polyanilin, Polyacetylen, Polyphenylenvinylen, Tetracyanochinodimethan, Tetrathiafulvalen und einer Kombination davon;
und wobei die halbleitende Nanostruktur vom n-Typ in das halbleitende konjugierte Molekül vom p-Typ dispergiert wird; und
b) Bestrahlen des in Schritt (a) erhaltenen Films mit UV-VIS-Strahlung mit einer Leistung zwischen 1 mW/cm² und 100 mW/cm² und einer Belichtungszeit zwischen 0,1 s und 600 s und in Gegenwart einer sauerstoffhaltigen Atmosphäre.

3. Verfahren nach Anspruch 2, wobei das halbleitende konjugierte organische Molekül vom p-Typ aus Schritt (a) Poly(3-hexylthiophen), Poly(3-dodecylthiophen-2,5-diyl) oder Poly(9,9-dioctylfluoren) ist.

4. Verfahren nach einem der Ansprüche 2 oder 3, wobei die halbleitende Nanostruktur vom n-Typ aus Schritt (a) einen Gewichtsprozentbereich zwischen 20% und 40% aufweist.

5. Verfahren nach einem der Ansprüche 2 bis 4, wobei Schritt a) die folgenden Schritte umfasst:
a1) Zugeben einer Lösung eines halbleitenden konjugierten Moleküls vom p-Typ, die ein halbleitendes konjugiertes Molekül vom p-Typ und ein Lösungsmittel enthält, zu einer Dispersion einer halbleitenden Nanostruktur vom n-Typ, umfassend eine halbleitende Nanostruktur vom n-Typ und ein Lösungsmittel;
a2) Rühren der in (a1) erhaltenen Mischung in einem Temperaturbereich zwischen -20 °C und 200 °C; und
a3) Abscheiden der Lösung, die in Schritt (a2) erhalten wurde, auf ein Substrat.

6. Verfahren nach Anspruch 5, wobei Schritt (a2) in einem Temperaturbereich zwischen 0 °C und 100 °C durchgeführt wird.

7. Verfahren nach einem der Ansprüche 5 oder 6, **dadurch gekennzeichnet, dass** es einen Schritt (a1') zwischen Schritt (a1) und Schritt (a2) des Zugebens eines Tensids zu der in (a1) erhaltenen Mischung umfasst.

8. Verfahren nach einem der Ansprüche 5 bis 6, wobei der in Schritt (a3) erhaltene nasse Film eine Dicke zwischen 10 µm und 1000 µm aufweist.

9. Verfahren nach Anspruch 8, wobei der in Schritt (a3) erhaltene nasse Film eine Dicke zwischen 100 µm und 1000 µm aufweist.

10. Verfahren nach einem der Ansprüche 1 bis 9, wobei Schritt a) die folgenden Schritte umfasst:
die Schritte (a1) bis (a3) nach einem der Ansprüche 7 oder 8; und
einen Schritt (a4) zum Trocknen des in Schritt (a3) erhaltenen nassen Films durch Verdampfen der Lösungsmittel, wobei der in Schritt (a4) erhaltene getrocknete Film eine Dicke zwischen 10 nm und 100 µm aufweist.

11. Verfahren nach Anspruch 10, wobei der in Schritt (a4) erhaltene getrocknete Film eine Dicke zwischen 1 µm und 10 µm aufweist.

12. Verfahren zur Erhaltung eines organischen Halbleiters vom p-Typ aus einem organischen Halbleiter vom n-Typ nach Anspruch 1, **dadurch gekennzeichnet, dass** das Verfahren die folgenden Schritte umfasst:
a) Herstellen eines Films eines organischen Halbleiters vom n-Typ auf einem flexiblen Substrat, ausgewählt aus Polyethylenterephthalat, Polyethylennaphthalat, Polyimid, Polyethylen, Polystyrol, Poly(vinylchlorid), Polytetrafluorethylen, Polypropylen, Polyurethan, Polyvinylidenfluorid und einer Kombination davon,
wobei der organische Halbleiter vom n-Typ umfasst
• eine halbleitende Nanostruktur vom p-Typ mit einem Gewichtsprozentbereich zwischen 0,1% und 80%; ausgewählt aus makellosen einzel-doppel- und mehrwandigen Kohlenstoffnanoröhren, Graphenfolien und Graphitnanoplättchen, Graphennanobändern; bordotierten einzel-, doppel- und mehrwandigen Kohlenstoffnanoröhren, bordotierten Graphenfolien und bordotierten Graphitnanoplättchen, bordotierten Graphennanobändern, bordotierten Fullerenen und eine Kombination davon; und
• ein elektronenreiches Molekül, ausgewählt aus Polyethylenimin (PEI), Diethylentriamin (DETA), Tetramethylammoniumhydroxid (TMAH), Tetrakis(dimethylamino)ethylen (TDAE), 4-H-Benzimidazol-2-yl)-N,N-Dimethylbenzolamin (N-DMBI), 4-H-N,N-Diphenylanilin (N-DPBI), Triphenylphosphin (tpp), 1,3-Bis(diphenylphosphino)propan (dppp);
und wobei die halbleitende Nanostruktur vom p-Typ in das elektronenreiche Molekül dispergiert wird; und
b) Bestrahlen des in Schritt (a) erhaltenen Films mit UV-VIS-Strahlung mit einer Leistung zwischen 1 mW/cm² und 100 mW/cm² und einer Belichtungszeit zwischen 0,1 s und 600 s und in Gegenwart einer sauerstoffhaltigen Atmosphäre.

13. Verfahren nach Anspruch 12, wobei die halbleitende Nanostruktur vom p-Typ aus Schritt (a) in einem Gewichtsprozentbereich zwischen 40% und 80% liegt.

14. Verfahren nach einem der Ansprüche 1 bis 13, wobei Schritt (b) durch UV-VIS-Strahlung mit einer Leistung zwischen 40 mW/cm² und 60 mW/cm² und einer Belichtungszeit zwischen 50 s und 100 s durchgeführt wird.

15. Verfahren nach einem der Ansprüche 1 bis 14, wobei Schritt (b) unter Verwendung einer Laserquelle, einer Diode oder einer Lampe durchgeführt wird.

## Revendications

1. Procédé d'obtention d'un semi-conducteur organique de type n à partir d'un semi-conducteur de type p ou d'un semi-conducteur organique de type p à partir d'un semi-conducteur organique de type n comprenant les étapes suivantes :
a) préparer un film d'un semi-conducteur organique de type p ou d'un semi-conducteur organique de type n sur un substrat, respectivement,
dans lequel le semi-conducteur organique comprend une nanostructure semi-conductrice et un accepteur ou donneur d'électrons respectivement ; et
b) irradier le film obtenu à l'étape (a) par un rayonnement UV-VIS avec une puissance comprise entre 1 mW/cm² et 100 mW/cm² **caractérisé en ce que** le temps d'exposition est compris entre 0,1 s et 600 s et que le processus est effectué en présence d'une atmosphère contenant de l'oxygène.

2. Procédé d'obtention d'un semi-conducteur organique de type n à partir d'un semi-conducteur de type p selon la revendication 1, **caractérisé en ce que** le procédé comprend les étapes suivantes :
a) préparer un film d'un semi-conducteur organique de type p sur un substrat flexible, ledit substrat souple choisi parmi le polyéthylène téréphtalate, le polyéthylène naphtalate, le polyimide, le polyéthylène, le polystyrène, la chlorure de polyvinyle, le polytétrafluoroéthylène, le polypropylène, le polyuréthane, le polyfluorure de vinylidène et une combinaison de ceux-ci,
dans lequel ledit semi-conducteur organique de type p comprend
• une nanostructure semi-conductrice de type n comprise entre 0,1 % et 60 % en poids ; ladite nanostructure semi-conductrice de type n choisie dans la liste consistant en les nanotubes de carbone dopés N, les feuilles de graphène et les nanoplaquettes de graphite dopées N, les nanorubans de graphène dopés N, les fullerènes, les nanofils de silicium dopés au phosphore, les nanofils de tellure tels que les nanofils Bi₂Te₃ ou les nanofils PbTe, les nanofils à base d'oxyde de zinc, les nanofils à base d'oxyde de titane et une combinaison de ceux-ci, et
• une molécule conjuguée semi-conductrice de type p, ladite molécule organique conjuguée semi-conductrice de type p choisie parmi les polyalkylthiophènes, les polyfluorènes, la polyaniline, le polyacétylène, le polyphénylène vinylène, le tétracyanoquinodiméthane, le tétrathiafulvalène et une combinaison de ceux-ci ;
et dans lequel ladite nanostructure semi-conductrice de type n est dispersée dans la molécule conjuguée semi-conductrice de type p ; et
b) irradier le film obtenu à l'étape (a) par un rayonnement UV-VIS avec une puissance comprise entre 1 mW/cm² et 100 mW/cm² et un temps d'exposition compris entre 0,1 s et 600 s et en présence d'une atmosphère contenant de l'oxygène.

3. Procédé de contrôle selon la revendication 2, dans lequel la molécule organique conjuguée semi-conductrice de type p de l'étape (a) est un poly(3-hexylthiophène), le poly(3-dodécylthiophène-2,5-diyl) ou le poly(9,9-dioctylfluorène).

4. Procédé selon l'une quelconque des revendications 2 ou 3, dans lequel la nanostructure semi-conductrice de type n de l'étape (a) est comprise entre 20 % et 40 % en poids.

5. Procédé selon l'une quelconque des revendications 2 à 4, dans lequel l'étape a) comprend les étapes suivantes :
a1) ajouter une solution de molécule conjuguée semi-conductrice de type p comprenant une molécule conjuguée semi-conductrice de type p et un solvant à une dispersion de nanostructure semi-conductrice de type n comprenant une nanostructure semi-conductrice de type n et un solvant ;
a2) agiter le mélange obtenu dans (a1) à une plage de température entre - 20 °C et 200 °C ; et
a3) déposer la solution obtenue à l'étape (a2) sur un substrat.

6. Procédé de contrôle selon la revendication 5, dans lequel l'étape (a2) est effectuée dans une plage de température comprise entre 0 °C et 100 °C.

7. Procédé selon l'une quelconque des revendications 5 ou 6, **caractérisé en ce qu'**il comprend une étape (a1'), entre l'étape (a1) et l'étape (a2), consistant à ajouter un tensioactif au mélange obtenu à (a1).

8. Procédé selon l'une quelconque des revendications 5 à 6, dans lequel le film humide obtenu à l'étape (a3) a une épaisseur comprise entre 10 µm et 1000 µm.

9. Procédé de contrôle selon la revendication 8, dans lequel le film humide obtenu à l'étape (a3) a une épaisseur comprise entre 100 µm et 1000 µm.

10. Procédé selon l'une quelconque des revendications 1 à 9, dans lequel l'étape a) comprend les étapes suivantes :
les étapes (a1) à (a3) selon l'une quelconque des revendications 7 ou 8 ; et
une étape (a4) de séchage du film humide obtenu à l'étape (a3) en évaporant les solvants, dans lequel le film séché obtenu à l'étape (a4) a une épaisseur comprise entre 10 nm et 100 µm.

11. Procédé de contrôle selon la revendication 10, dans lequel le film séché obtenu à l'étape (a4) a une épaisseur comprise entre 1 µm et 10 µm.

12. Procédé d'obtention d'un semi-conducteur organique de type p à partir d'un semi-conducteur organique de type n selon la revendication 1, **caractérisé en ce que** le procédé comprend les étapes suivantes :
a) préparer un film d'un semi-conducteur organique de type n sur un substrat flexible et choisi parmi le polyéthylène téréphtalate, le polyéthylène naphtalate, le polyimide, le polyéthylène, le polystyrène, la chlorure de polyvinyle, le polytétrafluoroéthylène, le polypropylène, le polyuréthane, le polyfluorure de vinylidène et une combinaison de ceux-ci,
dans lequel ledit semi-conducteur organique de type n comprend
• une nanostructure semi-conductrice de type p comprise entre 0,1 % et 80 % en poids ; choisi parmi les nanotubes de carbone simple, double, et plusieurs parois, les feuilles de graphène et les nanoplaquettes de graphite, les nanorubans de graphène ; les nanotubes de carbone simple, double et multi-parois dopés au bore, les feuilles de graphène dopées au bore et les nanoplaquettes de graphite dopées au bore, les nanorubans de graphène dopés au bore, les fullerènes dopés au bore et une combinaison de ceux-ci ; et
• une molécule riche en électrons choisie parmi la polyéthylèneimine (PEI), le diéthylènetriamine (DETA), l'hydroxyde de tétraméthylammonium (TMAH), le tétrakis(diméthylamino)éthylène (TDAE), le 4-H-benzimidazol-2-yl)-N,N-diméthylbenzénamine (N-DMBI), le 4-HN,N-diphénylaniline (N-DPBI), le triphénylphosphine (tpp), le 1,3-bis(diphénylphosphino)propane (dppp) ;
et dans lequel ladite nanostructure semi-conductrice de type p est dispersée dans la molécule riche en électrons ; et
b) irradier le film obtenu à l'étape (a) par un rayonnement UV-VIS avec une puissance comprise entre 1 mW/cm² et 100 mW/cm² et un temps d'exposition compris entre 0,1 s et 600 s et en présence d'une atmosphère contenant de l'oxygène.

13. Procédé de contrôle selon la revendication 12, dans lequel la nanostructure semi-conductrice de type p de l'étape (a) se situe dans une plage allant de 40 % à 80 % en poids.

14. Procédé selon l'une quelconque des revendications 1 à 13, dans lequel l'étape (b) est réalisée par rayonnement UV-VIS avec une puissance comprise entre 40 mW/cm² et 60 mW/cm² et un temps d'exposition compris entre 50 et 100 s.

15. Procédé selon l'une quelconque des revendications 1 à 14, dans lequel l'étape (b) est réalisée en utilisant une source laser, une diode ou une lampe.
